# EUROPÄISCHE PATENTSCHRIFT

(11) **EP 4 163 598 B1**
(45) Veröffentlichungstag und Bekanntmachung des Hinweises auf die Patenterteilung: **09.08.2023**
(21) Anmeldenummer: 21201378.3
(22) Anmeldetag: 07.10.2021
(51) Int. Cl.: G01D 5/14, G01D 11/24, G01D 11/30

(54) **GEHÄUSE ZUR AUFNAHME ELEKTRISCHER UND/ODER ELEKTRONISCHER BAUTEILE**
CASING FOR THE INSTALLATION OF ELECTRIC OR ELECTRONIC COMPONENTS
BOÎTIER DESTINÉ AU LOGEMENT DE COMPOSANTS ÉLECTRIQUES ET/OU ÉLECTRONIQUES

(43) Veröffentlichungstag der Anmeldung: 12.04.2023
(73) Patentinhaber: Baumer Germany GmbH & Co. KG, 78333 Stockach (DE)
(72) Erfinder: Käbberich, Philipp, 37276 Meinhard (DE)
(74) Vertreter: Strauss, Steffen

(56) Entgegenhaltungen:
- EP-A1- 1 564 529
- EP-A1- 2 693 582
- DE-A1-102014 102 930
- DE-C1- 10 119 910
- DE-U- 9 104 532

## Beschreibung

Die Erfindung betrifft ein Gehäuse zur Aufnahme elektrischer und/oder elektronischer Bauteile, insbesondere ein Gehäuse zur Aufnahme elektrischer und/oder elektronischer Bauteile eines Sensors, beispielsweise eines Drehgebers oder eines induktiven, kapazitiven oder optischen Näherungsschalters.

Bei Sensoren, wie Drehgebern oder Näherungsschalter, sind die eigentlichen Sensorelemente sowie weitere elektrische und elektronische Bauteile, beispielsweise eine Auswerteschaltung, in der Regel in einem Gehäuse angeordnet. Für eine elektrische Verbindung mit weiteren Geräten, beispielsweise einer zentralen Steuerung, weist das Gehäuse üblicherweise einen Anschlussstutzen auf, der als Kabel- oder Steckerausgang dient. Ein derartiges Gehäuse ist beispielsweise aus der EP 1 610 603 B1 bekannt.

Aus der Druckschrift DE 10 119 910 C1 ist ein Gehäuse zur Aufnahme von elektrischen und / oder elektronischen Komponenten bekannt. Zum Anschluss an externe Einheiten weist das Gehäuse einen drehbar gelagerten Drehkörper auf, welcher mit einem Sprengring in einer Bohrung des Gehäuses fixiert ist. Zur Begrenzung der Drehbewegung des Drehkörpers sind im Bereich der Bohrung des Gehäuses und dem Drehkörper Vorsprünge vorgesehen, die als Anschläge dienen.

Die Druckschrift EP 15 645 29 A1 betrifft eine Winkelmesseinrichtung mit einer Kappe, einem Anschlusskabel und einem Federelement, welches an der Kappe angeordnet ist. Zur Fixierung des Anschlusskabels ist durch das Federelement eine Kraft erzeugbar, die bezüglich des Anschlusskabels einen radiale Richtungskomponente aufweist, wobei durch diese Kraft das Anschlusskabel an die Kappe gedrückt wird.

Die Druckschrift DE 91 045 32 U1 zeigt eine Kniehebelspannvorrichtung für den Karosseriebau mit einem Stecker für die Stromzuführung der Endschalter, wobei der Stecker in unterschiedlichen Stellung an der Kniehebelspannvorrichtung anzuordnen ist.

Der vorliegenden Erfindung liegt die Aufgabe zu Grunde, ein verbessertes Gehäuse zur Aufnahme elektrischer und/oder elektronischer Bauteile bereitzustellen, insbesondere ein Gehäuse zur Aufnahme elektrischer und/oder elektronischer Bauteile eines Sensors, beispielsweise eines Drehgebers oder eines induktiven, kapazitiven oder optischen Näherungsschalters.

Gemäß einem ersten Aspekt der Erfindung wird die vorstehende Aufgabe durch ein Gehäuse mit einem Gehäusekörper gelöst, der einen Hohlraum zur Aufnahme von elektrischen und/oder elektronischen Bauteilen und eine Gehäuseöffnung definiert. Das Gehäuse umfasst ferner einen Winkelstecker, welcher einen ersten im Wesentlichen zylinderförmigen Abschnitt mit einer ersten Steckerlängsachse aufweist, der ausgebildet ist, in einer tangentialen Orientierung hinsichtlich des Gehäusekörpers in der Gehäuseöffnung aufgenommen zu werden. Der Gehäusekörper umfasst ferner einen Fixierungsstift, der ausgebildet ist, in eine Fixierungsnut auf einer Außenseite des ersten zylinderförmigen Abschnitts des Winkelsteckers einzugreifen, um eine Position des Winkelsteckers entlang der ersten Steckerlängsachse zu fixieren. Dabei erstreckt sich die Fixierungsnut nur über einen Teil des Umfangs des ersten zylinderförmigen Abschnitts des Winkelsteckers, um einen ersten Endanschlag und einen zweiten Endanschlag für eine Schwenkbewegung des Winkelsteckers um die erste Steckerlängsachse auszubilden.

Aufgrund des erfindungsgemäßen Zusammenwirkens des Fixierungsstiftes mit der fluchtend zum Fixierungsstift ausgebildeten Fixierungsnut wird der Winkelstecker zum einen axial fixiert, ist aber um die erste Steckerlängsachse drehbar gelagert, d.h. kann zwischen dem ersten Endanschlag und dem zweiten Endanschlag um die erste Steckerlängsachse verschwenkt werden. Somit können vorteilhaft verschiedene Anschlussstellungen des Winkelsteckers realisiert werden, beispielsweise eine axiale und eine radiale Anschlussstellung des Winkelsteckers. Überdies ermöglicht das tangentiale Anbringen des Winkelsteckers an dem Gehäusekörper eine effiziente Nutzung des durch den Gehäusekörper definierten Bauraums.

Erfindungsgemäss umfasst der Gehäusekörper eine im Wesentlichen kreisförmige Gehäusegrundfläche und einen im Wesentlichen zylinderförmigen Gehäusemantel, wobei die tangentiale Orientierung des ersten zylinderförmigen Abschnitts des Winkelsteckers hinsichtlich des Gehäusekörpers eine tangentiale Orientierung der ersten Steckerlängsachse des ersten zylinderförmigen Abschnitts des Winkelsteckers hinsichtlich des Umfangs der im Wesentlichen kreisförmigen Gehäusegrundfläche und des im Wesentlichen zylinderförmigen Gehäusemantels ist.

Gemäß einer Ausführungsform erstreckt sich die Fixierungsnut in einem Winkel von ungefähr 90° nur über den Teil des Umfangs des ersten zylinderförmigen Abschnitts des Winkelsteckers.

In einer Ausführungsform kann der erste zylinderförmige Abschnitt des Winkelsteckers einen äußeren Dichtungsring, insbesondere einen O-Ring umfassen, welcher ausgebildet ist, den durch den Gehäusekörper definierten Hohlraum abzudichten. Hierdurch kann vorteilhafterweise vermieden werden, dass Schmutzpartikel und/oder Feuchtigkeit über die Gehäuseöffnung in das Gehäuse eintreten und die Funktionstüchtigkeit der dort aufgenommenen elektrischen und/oder elektronischen Bauteilen beinträchtigen können. Gemäß einer Ausführungsform kann der erste zylinderförmige Abschnitt des Winkelsteckers ferner einen Rastring mit einer Außenriffelung umfassen, welcher ausgebildet ist, in eine Innenriffelung in der Gehäuseöffnung des Gehäusekörpers einzugreifen, um eine rastende Schwenkbewegung des Winkelsteckers um die erste Steckerlängsachse zwischen dem ersten Endanschlag und dem zweiten Endanschlag auszubilden.

In einer Ausführungsform umfasst der Rastring wenigstens einen axial verlaufenden Schlitz und ist auf der Außenseite des ersten zylinderförmigen Abschnitts des Winkelsteckers aufgesteckt, wobei auf der Außenseite des ersten zylinderförmigen Abschnitts des Winkelsteckers wenigstens ein axial verlaufender Steg ausgebildet ist, welcher in dem wenigstens einen axial verlaufenden Schlitz aufgenommen ist, um ein nachteiliges Verdrehen des aufgesteckten Rastrings relativ zu dem ersten zylinderförmigen Abschnitt des Winkelsteckers zu verhindern.

Insbesondere bei Ausführungsformen mit dem Rastring kann der erste zylinderförmige Abschnitt des Winkelsteckers ferner einen inneren Dichtungsring umfassen, welcher ausgebildet ist, den durch den Gehäusekörper definierten Hohlraum gegenüber dem Rastring abzudichten. Hierdurch kann vorteilhaft verhindert werden, dass der bei der Betätigung des Rastring entstehende Abrieb die Funktionstüchtigkeit der im Gehäuse aufgenommenen elektrischen und/oder elektronischen Bauteile beeinträchtigt.

In einer Ausführungsform ist der Rastring aus Kunststoff mit in den Kunststoff eingebrachten elektrisch leitfähigen Partikeln ausgeführt. Zudem ist der Gehäusekörper elektrisch leitfähig ausgeführt. Dies hat den Vorteil, dass ein elektrischer Kontakt über den Rastring des Winkelstecker mit dem Gehäusekörper hergestellt wird, wodurch die elektromagnetische Verträglichkeit verbessert ist und ein EMV-Schutz erhöht wird.

Gemäß einer Ausführungsform umfasst der Winkelstecker einen zweiten zylinderförmigen Abschnitt mit einer zweiten Steckerlängsachse, welche in einem Winkel, insbesondere einem rechten Winkel, zu der ersten Steckerlängsachse verläuft, wobei der zweite zylinderförmige Abschnitt des Winkelsteckers ein Außengewinde und/oder einen Steckereinsatz umfasst.

In einer Ausführungsform umfasst der Fixierungsstift einen Passkerbstift, welcher in einen Sitz des Gehäusekörpers eingesteckt ist.

Gemäß einem zweiten Aspekt der Erfindung wird ein Drehgeber mit einem Gehäuse gemäß dem ersten Aspekt der Erfindung bereitgestellt.

Im Folgenden wird die Erfindung anhand von Ausführungsbeispielen und den Figuren näher beschrieben. In den Figuren zeigen:
- Fig. 1: eine perspektivische Ansicht eines Gehäuses gemäß einer Ausführungsform mit einem Gehäusekörper und einem in einer Öffnung des Gehäusekörpers aufgenommenen Winkelstecker;
- Fig. 2: eine perspektivische Ansicht des Gehäusekörpers eines Gehäuses gemäß einer Ausführungsform;
- Fig. 3a-c: perspektivische Ansichten (teilweise im Schnitt) eines Gehäuses gemäß einer Ausführungsform mit einem Gehäusekörper und einem in einer Öffnung des Gehäusekörpers aufgenommenen Winkelstecker;
- Fig. 4: eine Draufsicht eines Gehäuses gemäß einer Ausführungsform mit einem Gehäusekörper und einem in einer Öffnung des Gehäusekörpers aufgenommenen Winkelstecker;
- Fig. 5a,b: eine Explosionsdarstellung und eine Draufsicht des Winkelsteckers eines Gehäuses gemäß einer Ausführungsform; und
- Fig. 6: eine Seitenansicht eines Gehäuses gemäß einer Ausführungsform mit einem Gehäusekörper und einem in einer Öffnung des Gehäusekörpers aufgenommenen Winkelstecker in einer ersten und einer zweiten Endposition.

In der folgenden ausführlichen Beschreibung wird auf die beiliegenden Figuren Bezug genommen, die einen Teil hiervon bilden und in denen als Veranschaulichung spezifische Ausführungsformen gezeigt sind, in denen die Erfindung ausgeführt werden kann. Es versteht sich, dass auch andere Ausführungsformen genutzt und strukturelle oder logische Änderungen vorgenommen werden können, ohne von dem Konzept der vorliegenden Erfindung abzuweichen. Die folgende ausführliche Beschreibung ist deshalb nicht in einem beschränkenden Sinne zu verstehen. Ferner versteht es sich, dass die Merkmale der verschiedenen hierin beschriebenen Ausführungsbeispiele miteinander kombiniert werden können, sofern nicht spezifisch etwas anderes angegeben ist.

Die Aspekte und Ausführungsformen der vorliegenden Erfindung werden unter Bezugnahme auf die Figuren beschrieben, wobei gleiche Bezugszeichen sich im Allgemeinen auf gleiche Elemente beziehen. In der folgenden Beschreibung werden zu Erläuterungszwecken zahlreiche spezifische Details dargelegt, um ein eingehendes Verständnis von einem oder mehreren Aspekten der vorliegenden Erfindung zu vermitteln.

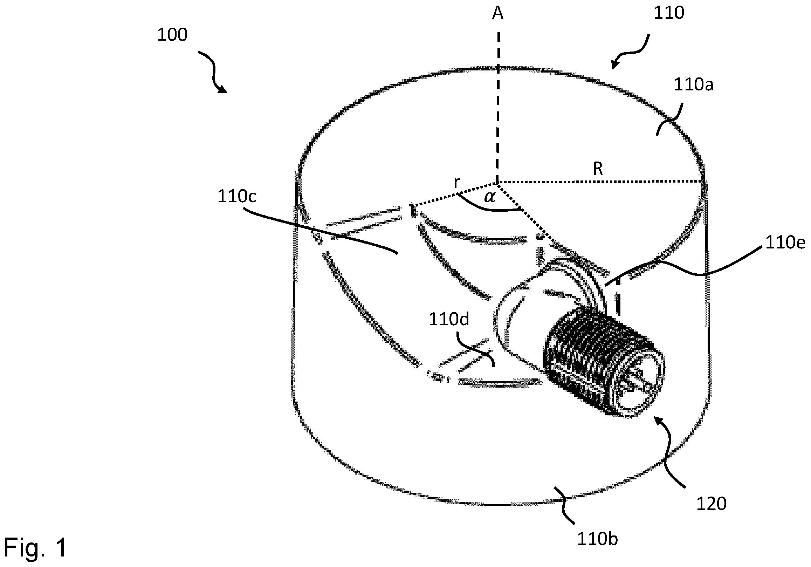

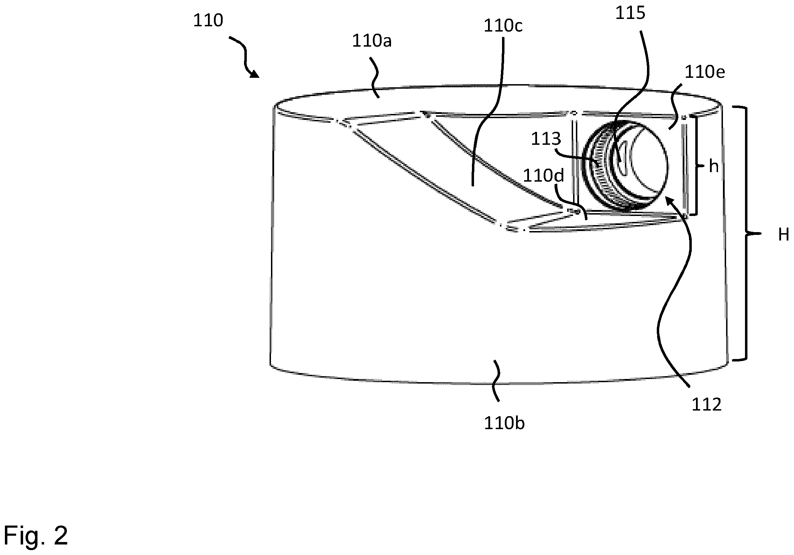

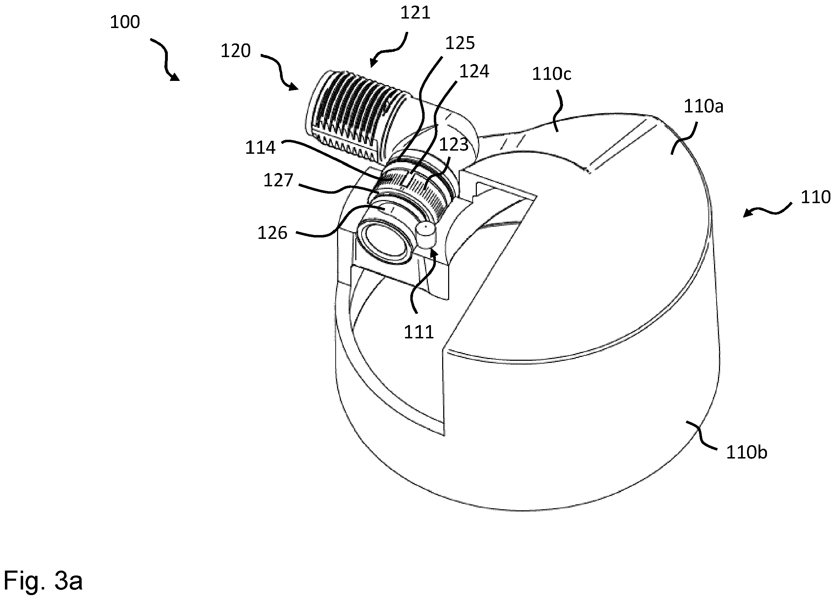

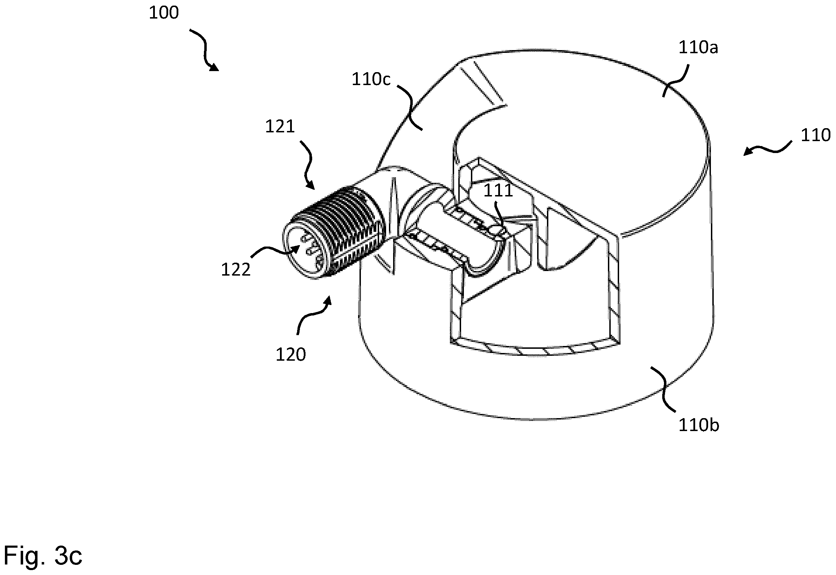

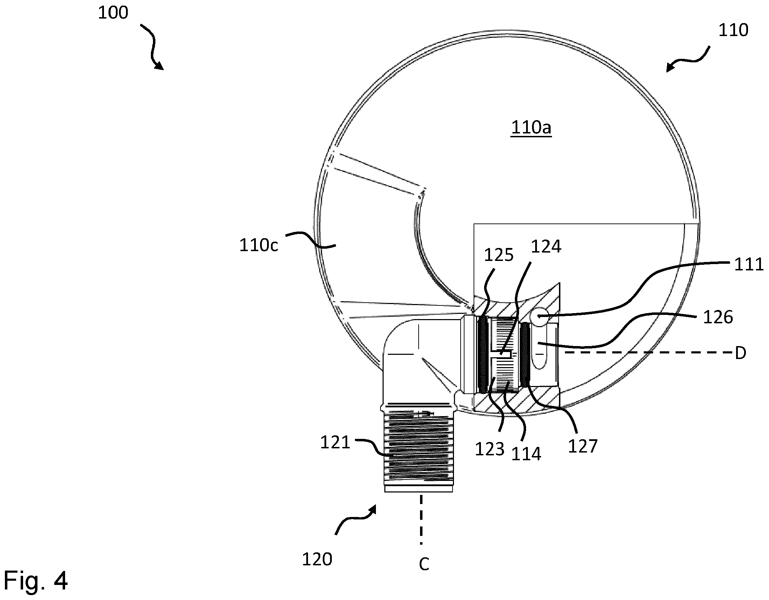

Figur 1 zeigt eine perspektivische Ansicht eines Gehäuses 100 gemäß einer Ausführungsform zur Aufnahme elektrischer und/oder elektronischer Bauteile, insbesondere ein Gehäuse 100 zur Aufnahme elektrischer und/oder elektronischer Bauteile eines Sensors, beispielsweise eines Drehgebers oder eines induktiven, kapazitiven oder optischen Näherungsschalters. Das Gehäuse 100 umfasst einen Gehäusekörper 110, der aus einem Kunststoff bestehen kann, und einen Winkelstecker 120, welcher in einer in Figur 2 dargestellten Öffnung 112 des Gehäusekörpers 110 aufnehmbar ist. Weitere Ansichten des Gehäuses 100 von Figur 1 sind in den Figuren 3a-c und 4 dargestellt.

Wie dies insbesondere den Figuren 1 und 2 entnommen werden kann, umfasst der Gehäusekörper 110 eine im Wesentlichen kreisförmige Gehäusegrundfläche 110a (oder Deckenfläche 110a) und einen im Wesentlichen zylinderförmigen Gehäusemantel 110b. Die Gehäusegrundfläche 110a und der zylinderförmige Gehäusemantel 110b, der ein offenes unteres Ende aufweisen kann, definieren einen Hohlraum zur Aufnahme elektrischer und/oder elektronischer Bauteile, insbesondere elektrischer und/oder elektronischer Bauteile eines Sensors. Ferner definieren die Gehäusegrundfläche 110a und der zylinderförmige Gehäusemantel 110a eine Längsachse A des Gehäusekörpers 110.

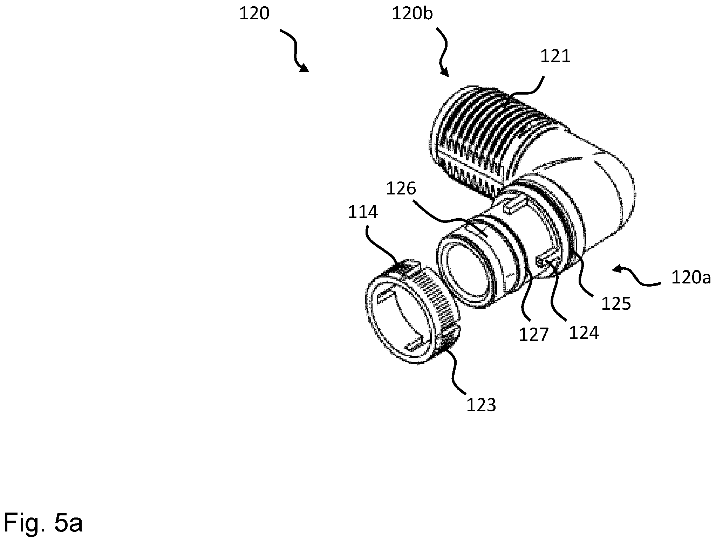

Zur nachstehenden im Detail beschriebenen tangentialen Aufnahme eines ersten Abschnitts 120a (siehe Fig. 5a) des Winkelsteckers 120 in der Öffnung 112 umfasst der Gehäusekörper 110 ferner einen abgesenkten Plateauabschnitt 110d sowie einen Übergangsabschnitt 110c, der einen Übergang von der Gehäusegrundfläche 110a zu dem gegenüber der Gehäusegrundfläche 110a abgesenkten Plateauabschnitt 110d ausbildet. Der Gehäusekörper 110 umfasst ferner eine Gehäuseoberfläche 110e, welche sich von einer Kante des abgesenkten Plateauabschnitts 110d senkrecht in Richtung der Längsachse A, d.h. axial nach oben zu der Gehäusegrundfläche 110a erstreckt, wobei in der Gehäuseoberfläche 110e die Öffnung 112 zur Aufnahme des ersten Abschnitts 120a des Winkelsteckers 120 ausgebildet ist.

Wie dies wiederum insbesondere den Figuren 1 und 2 entnommen werden kann, definieren der Übergangsabschnitt 110c sowie der gegenüber der Gehäusegrundfläche 110a abgesenkte Plateauabschnitt 110d des Gehäusekörpers 110 in Draufsicht im Wesentlichen einen Kreisringsektor der im Wesentlichen kreisförmigen Gehäusegrundfläche 110a. Der durch den Übergangsabschnitt 110c und den abgesenkten Plateauabschnitt 110d definierte Kreisringsektor umfasst einen Innenradius r und einen Außenradius R und erstreckt sich über einen Winkel *α*. In einer Ausführungsform kann der Innenradius r ungefähr 10 bis 20 mm, insbesondere ungefähr 15 mm betragen. In einer Ausführungsform kann der Außenradius R der Gehäusegrundfläche 110a ungefähr 20 bis 40 mm, insbesondere ungefähr 30 mm betragen. In einer Ausführungsform kann der Winkel *α* ungefähr 90° bis 130°, insbesondere ungefähr 110° betragen.

Wie in Figur 2 dargestellt, erstreckt sich die Gehäuseoberfläche 110e, welche die Öffnung 112 definiert, über eine Höhe h von dem abgesenkten Plateauabschnitt 110d in Richtung der Längsachse A zu der Gehäusegrundfläche 110a, wobei die Höhe h kleiner als die im Wesentlichen durch den zylinderförmigen Gehäusemantel 110b definierte Gesamthöhe H des Gehäusekörpers 110 ist. In einer Ausführungsform kann die Höhe h der Gehäuseoberfläche 110e ungefähr 8 bis 18 mm, insbesondere ungefähr 13 mm betragen. In einer Ausführungsform kann die im Wesentlichen durch den zylinderförmigen Gehäusemantel 110b definierte Gesamthöhe H des Gehäusekörpers 110 ungefähr 20 bis 50 mm, insbesondere ungefähr 35 mm betragen.

Wie bereits vorstehend beschrieben, ist der Gehäusekörper 110 ausgebildet, den ersten Abschnitt 120a des Winkelsteckers 120 tangential in der Öffnung 112 aufzunehmen. Dabei bedeutet, die tangentiale Aufnahme des ersten Abschnitts 120a des Winkelsteckers 120 in der Öffnung 112, dass die durch den ersten Abschnitt 120a des Winkelsteckers 120 definierte Längsachse D im Wesentlichen tangential zu dem Kreisumfang der kreisförmigen Gehäusegrundfläche 110a bzw. zu dem zylinderförmigen Gehäusemantel 110b verläuft, wie dies in der Draufsicht von Figur 4 dargestellt ist.

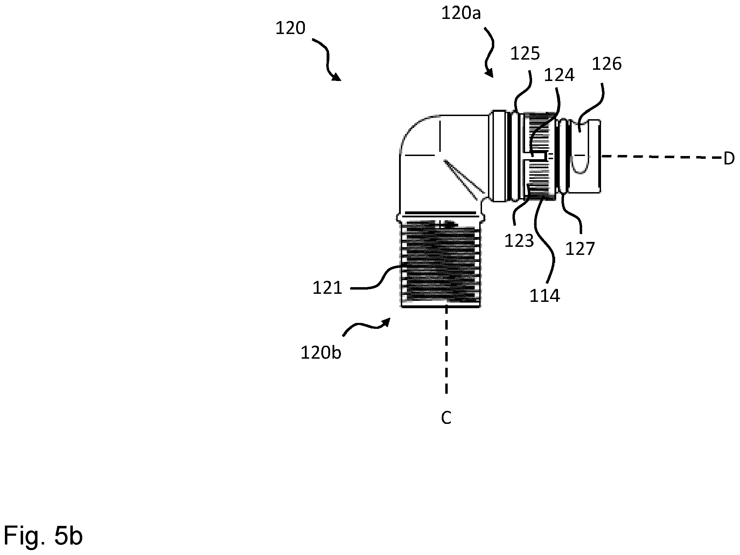

Unter weiterer Bezugnahme auf die Figuren 5a und 5b, die eine Explosionsdarstellung und eine Draufsicht des Winkelsteckers 120 des Gehäuses 100 gemäß einer Ausführungsform zeigen, werden im folgenden weitere erfindungsgemäße Merkmale des Winkelsteckers 120 beschrieben (die teilweise auch insbesondere in den Figuren 3a-c dargestellt sind). Wie bereits vorstehend beschrieben, umfasst der Winkelstecker 120 einen ersten im Wesentlichen zylinderförmigen Abschnitt 120a, der, wie in den Figuren 4 und 5b dargestellt, eine erste Steckerlängsachse D definiert und teilweise in der Öffnung 112 des Gehäusekörpers 110 aufgenommen ist, sowie einen zweiten im Wesentlichen zylinderförmigen Abschnitt 120b, der eine zweite Steckerlängsachse C definiert, welche im Wesentlichen senkrecht zu der ersten Steckerlängsachse D verläuft. Dabei kann der zweite Abschnitt 120b des Winkelsteckers 120 ein Außengewinde 121 sowie einen Steckereinsatz 122 zum Anschließen eines komplementär ausgebildeten weiteren Steckers umfassen.

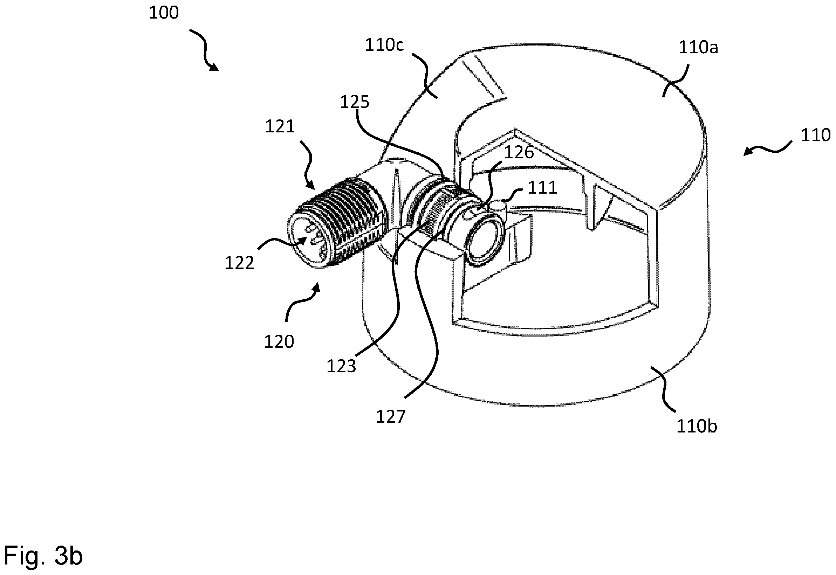

In einer Ausführungsform kann der Steckereinsatz 122 acht Pole aufweisen (siehe z.B. Figur 3b). Bei dem Außengewinde 121 kann es sich beispielsweise um ein M12x1 Gewinde für 8 polige Standard-Stecker handeln. Über das Außengewinde 121 und den Steckereinsatz 122 kann beispielsweise ein Versorgungs- und/oder Signalkabel für die in dem Gehäusekörper 110 verbauten elektrischen und/oder elektronischen Bauteile angeschlossen werden.

Wie dies insbesondere den Figuren 5a und 5b entnommen werden kann, umfasst der erste Abschnitt 120a des Winkelsteckers 120, der zumindest teilweise in der Öffnung 112 des Gehäusekörpers 110 aufgenommen wird, einen ersten äußeren Dichtungsring 125, einen zweiten inneren Dichtungsring 127, einen Rastring 123 und eine Fixierungsnut 126, deren Funktion im Folgenden detaillierter beschrieben wird.

Wie sich dies insbesondere aus einer Zusammenschau der Figuren 2, 3a, 3b und 4 ergibt, greift ein Fixierungsstift 111, der beispielsweise als Passkerbstift 111 ausgebildet sein kann und in einen Sitz 115 des Gehäusekörpers eingesteckt sein kann, in die auf der Außenseite des zylinderförmigen ersten Abschnitts 120a des Winkelsteckers 120 ausgebildete Fixierungsnut 126, um die Position des Winkelsteckers 120 in Richtung der ersten Steckerlängsachse D zu fixieren. Dabei verläuft die Fixierungsnut 126 nicht vollständig um den Umfang der Außenseite des zylinderförmigen ersten Abschnitts 120a des Winkelsteckers 120, sondern nur über einen Teil des Umfangs des ersten zylinderförmigen Abschnitts 120a des Winkelsteckers 120, um einen ersten Endanschlag und einen zweiten Endanschlag für eine Schwenkbewegung des Winkelsteckers 120 um die erste Steckerlängsachse D auszubilden. Mit anderen Worten: aufgrund des erfindungsgemäßen Zusammenwirkens des Fixierungsstiftes 111 mit der fluchtend zum Fixierungsstift 111 ausgebildeten Fixierungsnut 126 wird der Winkelstecker 120 zum einen axial fixiert, ist aber um die Steckerlängsachse D drehbar gelagert, d.h. kann zwischen dem ersten Endanschlag und dem zweiten Endanschlag um die Steckerlängsachse D verschwenkt werden.

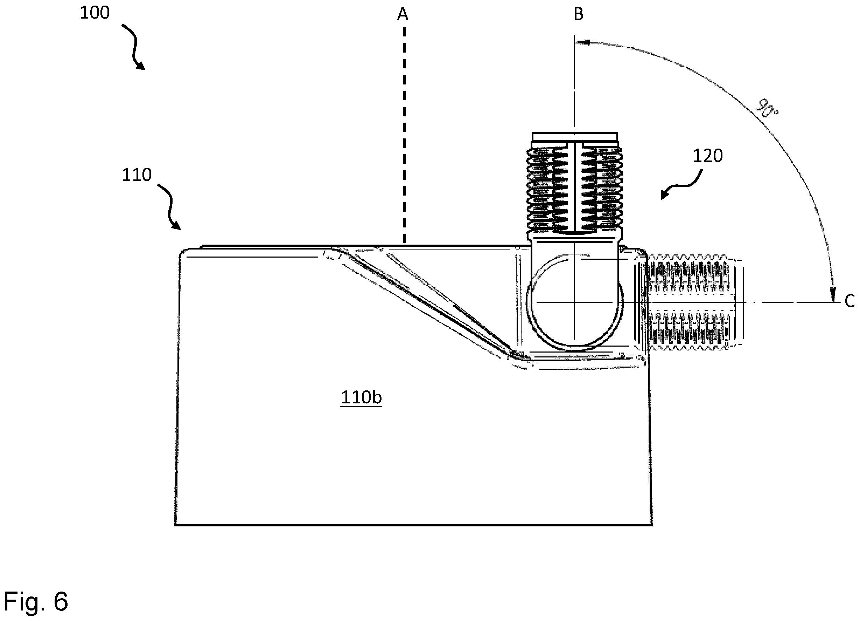

Figur 6 zeigt eine Seitenansicht des Gehäuses 100 gemäß einer Ausführungsform, wobei der erste Abschnitt des Winkelsteckers 120 teilweise in der Öffnung 112 des Gehäusekörpers 110 aufgenommen ist und die zwei Schwenkendpositionen des Winkelsteckers 120 dargestellt sind, welche durch die erfindungsgemäße Ausbildung der Fixierungsnut 126 im Zusammenwirken mit dem Fixierungsstift 111 definiert werden. Gemäß einer Ausführungsform erstreckt sich die Fixierungsnut 126 in einem Winkel von ungefähr 90° nur über den Teil des Umfangs des ersten zylinderförmigen Abschnitts 120a des Winkelsteckers 120, wie dies in Figur 6 durch die Achsen B und C veranschaulicht ist. Der Winkelstecker 120 kann somit in seinen zwei Endstellungen beispielsweise einen axialen und einen radialen Anschluss erzeugen.

Durch den Press- und Reibschluss an der Kontaktstelle der Fixierungsnut 126 mit dem Fixierungsstift 111 ergibt sich ein elektrisch leitender Kontakt, der den Winkelstecker 120 mit dem Gehäusekörper 110 verbindet und somit einen EMV-Schutz bietet.

Zusätzlich kann der Rastring 123 aus Kunststoff mit in den Kunststoff eingebrachten elektrisch leitfähigen Partikeln ausgeführt sein (in den Figuren nicht dargestellt). Zudem ist der Gehäusekörper 110 elektrisch leitfähig ausgeführt. Dies hat den Vorteil, dass ein elektrischer Kontakt über den Rastring 123 des Winkelstecker 120 mit dem Gehäusekörper 110 hergestellt wird, wodurch die elektromagnetische Verträglichkeit nochmals verbessert ist und ein EMV-Schutz erhöht wird.

Wie bereits vorstehend beschrieben, kann der erste zylinderförmige Abschnitt 120a des Winkelsteckers 120 einen äußeren Dichtungsring 125, insbesondere einen äußeren O-Ring 125 umfassen, welcher ausgebildet ist, den durch den Gehäusekörper 110 definierten Hohlraum abzudichten, in dem die elektrischen und/oder elektronischen Bauteile aufgenommen sind. Hierdurch kann vorteilhafterweise vermieden werden, dass Schmutzpartikel und/oder Feuchtigkeit über die Gehäuseöffnung 112 in den Gehäusekörper 110 eintreten und die Funktionstüchtigkeit der dort aufgenommenen elektrischen und/oder elektronischen Bauteile beinträchtigen.

Wie bereits vorstehend beschrieben, kann der erste zylinderförmige Abschnitt 120a des Winkelsteckers 120 ferner einen Rastring 123 mit einer Außenriffelung umfassen, welcher ausgebildet ist, in eine Innenriffelung 113 in der Gehäuseöffnung 112 des Gehäusekörpers 110 einzugreifen, um eine rastende Schwenkbewegung des Winkelsteckers 120 um die erste Steckerlängsachse D zwischen dem ersten Endanschlag und dem zweiten Endanschlag zu ermöglichen.

In einer Ausführungsform umfasst der Rastring 123 wenigstens einen axial verlaufenden Schlitz und ist auf der Außenseite des ersten zylinderförmigen Abschnitts 120a des Winkelsteckers 120 aufgesteckt. Auf der Außenseite des ersten zylinderförmigen Abschnitts 120a des Winkelsteckers 120 ist wenigstens ein axial verlaufender Steg 124 ausgebildet, welcher in dem wenigstens einen axial verlaufenden Schlitz aufgenommen ist, um ein nachteiliges Verdrehen des aufgesteckten Rastrings 123 relativ zu dem ersten zylinderförmigen Abschnitt 120a des Winkelsteckers 120 zu verhindern.

Zwischen einem Innendurchmesser des Rastring 123 und dem Aussendurchmesser des ersten Abschnittes 120a des Winkelstecker 120 ergibt sich ein geringer Luftspalt, der dazu dient es dem Rastring 123 zu ermöglichen, sich zu verformen. Erst so wird eine Drehbewegung ermöglicht.

Über die Größe dieses Luftspalts ist es möglich die Hemmung der Rasterung zu steuern. Es können somit verschiedene Rastringe 123, mit verschiedenen Innendurchmessern mit unterschiedlichen Rast-Intensitäten zum Einsatz kommen. Auch eine Winkelfixierung des Winkelsteckers 120 im Gehäusekörper 110 ist so realisierbar.

Insbesondere bei Ausführungsformen mit dem Rastring 123 kann der erste zylinderförmige Abschnitt 120a des Winkelsteckers 120 ferner einen inneren Dichtungsring 127 umfassen, welcher ausgebildet ist, den durch den Gehäusekörper 110 definierten Hohlraum gegenüber dem Rastring 123 abzudichten. Hierdurch kann vorteilhaft verhindert werden, dass der bei der Betätigung des Rastrings 123 entstehende Abrieb die Funktionstüchtigkeit der im Gehäusekörper 110 aufgenommenen elektrischen und/oder elektronischen Bauteile beeinträchtigt. Bei dem drehbaren Winkelstecker 120 können der äußere Dichtungsring 125 und/oder der innere Dichtungsring 127 ferner dazu dienen, den drehbaren Winkelstecker 120 mit ihrem Reibschluss als leichte Hemmung gegen ein Verdrehen zu sichern (insbesondere bei Ausführungsformen, bei denen der Rastring 123 nicht vorgesehen ist).

Das Ausbilden des Winkelsteckers 120 und das teilweise Einbringen des ersten Abschnitts 120a des Winkelsteckers 120 kann beispielsweise die folgenden Arbeitsschritte umfassen. Zunächst erfolgt eine Konfektionierung von beispielsweise acht einzelnen Litzen, die an einem Ende mit Crimp-Kontakten versehen werden. Diese Litzen mit ihren Crimp-Kontakten werden in einen 10 poligen JST-Stecker eingesteckt. In entsprechende O-Ringnuten auf der Außenseite der ersten Abschnitts 120 des Winkelsteckers werden die passenden Dichtungsringe 125, 127 eingelegt. Nun erfolgt das Einführen der einzelnen Litzen in den Winkelstecker 120 von der Seite aus, die später in den Gehäusekörper 110 gesteckt werden. Die aus dem Winkelstecker 120 herausragenden Litzen werden an die Kontakte des Steckereinsatzes 122 gelötet. Im folgenden Schritt wird der Steckereinsatz 122 in die für ihn ausgelegte Öffnung des zweiten Abschnitts 120b des Winkelsteckers 120 hineingedrückt. Das Innere des Winkelsteckers 120 wird mit einer 2K-Masse vergossen. Nach dem Aushärten der Vergussmasse kann der verkabelte Winkelstecker 120 im Gehäusekörper 110 verbaut werden, d.h. in die Gehäuseöffnung 112 eingebracht werden. Zuvor kann noch der Rastring 123 auf den Winkelstecker 120 gesteckt werden.

## Patentansprüche

1. Gehäuse (100) mit einem Gehäusekörper (110), der einen Hohlraum zur Aufnahme von elektrischen und/oder elektronischen Bauteilen und eine Gehäuseöffnung (112) definiert, und einem Winkelstecker (120),
welcher einen ersten zylinderförmigen Abschnitt (120a) mit einer ersten Steckerlängsachse (D) aufweist, der ausgebildet ist, in einer tangentialen Orientierung hinsichtlich des Gehäusekörpers (110) in der Gehäuseöffnung (112) aufgenommen zu werden,
wobei der Gehäusekörper (110) ferner einen Fixierungsstift (111) umfasst, der ausgebildet ist, in eine Nut (126) auf einer Außenseite des ersten zylinderförmigen Abschnitts (120a) des Winkelsteckers (120) einzugreifen, um eine Position des Winkelsteckers (120) entlang der ersten Steckerlängsachse (D) zu fixieren,
wobei sich die Nut (126) nur über einen Teil des Umfangs des ersten zylinderförmigen Abschnitts (120a) des Winkelsteckers (120) erstreckt, um einen ersten Endanschlag und einen zweiten Endanschlag für eine Schwenkbewegung des Winkelsteckers (120) um die erste Steckerlängsachse (D) auszubilden,
wobei der Gehäusekörper (110) eine im Wesentlichen kreisförmige Gehäusegrundfläche (110a) und einen im Wesentlichen zylinderförmigen Gehäusemantel (110b) umfasst und wobei die tangentiale Orientierung des ersten zylinderförmigen Abschnitts (120a) hinsichtlich des Gehäusekörpers (110) eine tangentiale Orientierung der ersten Steckerlängsachse (D) des ersten zylinderförmigen Abschnitts (120a) hinsichtlich des Umfangs der im Wesentlichen kreisförmigen Gehäusegrundfläche (110a) und des im Wesentlichen zylinderförmigen Gehäusemantels (110b) ist.

2. Gehäuse (100) nach Anspruch 1, wobei sich die Nut (126) in einem Winkel von ungefähr 90° nur über den Teil des Umfangs des ersten zylinderförmigen Abschnitts (120a) des Winkelsteckers (120) erstreckt.

3. Gehäuse (100) nach einem der vorhergehenden Ansprüche, wobei ein elektrisch leitender Kontakt des Winkelsteckers (120) mit dem Gehäusekörper (110) mittels einer Kontaktstelle der Nut (126) mit dem Fixierungsstift (111) herstellbar ist.

4. Gehäuse (100) nach Anspruch 3, wobei die Kontaktstelle mittels Press- und Reibschluss der Nut (126) mit dem Fixierungsstift (111) erfolgt.

5. Gehäuse (100) nach einem der vorhergehenden Ansprüche, wobei der erste zylinderförmige Abschnitt (120a) des Winkelsteckers (120) einen äußeren Dichtungsring (125) umfasst, welcher ausgebildet ist, den durch den Gehäusekörper (110) definierten Hohlraum abzudichten.

6. Gehäuse (100) nach einem der vorhergehenden Ansprüche, wobei der erste zylinderförmige Abschnitt (120a) des Winkelsteckers (120) einen Rastring (123) mit einer Aussenriffelung (114) umfasst.

7. Gehäuse (100) nach Anspruch 6, wobei die Aussenriffelung (114) des Rastrings (123) ausgebildet ist, in eine Innenriffelung (113) in der Gehäuseöffnung (112) des Gehäusekörpers (110) einzugreifen, um eine rastende Schwenkbewegung des Winkelsteckers (120) um die erste Steckerlängsachse (D) zwischen dem ersten Endanschlag und dem zweiten Endanschlag auszubilden.

8. Gehäuse (100) nach einem der Ansprüche 6 oder 7, wobei der Rastring (123) aus Kunststoff mit in den Kunststoff eingebrachten elektrisch leitfähigen Partikeln ausgeführt ist.

9. Gehäuse (100) nach einem der Ansprüche 6 bis 8, wobei der Rastring (123) wenigstens einen Schlitz aufweist und auf der Außenseite des ersten zylinderförmigen Abschnitts (120a) des Winkelsteckers (120) aufgesteckt ist und wobei auf der Außenseite des ersten zylinderförmigen Abschnitts (120a) des Winkelsteckers (120) wenigstens ein Steg (124) ausgebildet ist, welcher in dem wenigstens einen Schlitz aufgenommen ist, um ein Verdrehen des aufgesteckten Rastrings relativ zu dem ersten zylinderförmigen Abschnitt (120a) des Winkelsteckers (120) zu verhindern.

10. Gehäuse (100) nach Anspruch 9, wobei der erste zylinderförmige Abschnitt (120a) des Winkelsteckers (120) einen inneren Dichtungsring (127) umfasst, welcher ausgebildet ist, den durch den Gehäusekörper (110) definierten Hohlraum gegenüber dem Rastring (123) abzudichten.

11. Gehäuse (100) nach einem der vorhergehenden Ansprüche, wobei der Winkelstecker (120) einen zweiten zylinderförmigen Abschnitt (120b) mit einer zweiten Steckerlängsachse (C) umfasst, welche in einem Winkel, insbesondere einem rechten Winkel, zu der ersten Steckerlängsachse (D) verläuft.

12. Gehäuse (100) nach Anspruch 11, wobei der zweite zylinderförmige Abschnitt (120b) des Winkelsteckers (120) ein Außengewinde (121) und/oder einen Steckereinsatz (122) umfasst.

13. Gehäuse (100) nach einem der vorhergehenden Ansprüche, wobei der Fixierungsstift (111) einen Passkerbstift (111) umfasst, welcher in einen Sitz (115) des Gehäusekörpers (110) eingesteckt ist.

14. Sensor, insbesondere Drehgeber, mit einem Gehäuse (100) nach einem der vorhergehenden Ansprüche.

## Claims

1. Housing (100) comprising a housing body (110) that defines a hollow space for receiving electrical and/or electronic components and a housing opening (112), and a angle connector (120),
which has a first cylindrical section (120a) having a first longitudinal connector axis (D) that is designed to be received in the housing opening (112) in a tangential orientation with respect to the housing body (110),
wherein the housing body (110) also comprises a securing pin (111) that is designed to engage in a groove (126) on an outer face of the first cylindrical section (120a) of the angle connector (120) in order to secure a position of the angle connector (120) along the first longitudinal connector axis (D),
wherein the groove (126) only extends across part of the circumference of the first cylindrical section (120a) of the angle connector (120) in order to form a first end stop and a second end stop for a pivoting movement of the angle connector (120) around the first longitudinal connector axis (D),
wherein the housing body (110) comprises an essentially circular housing surface area (110a) and an essentially cylindrical housing jacket (110b) and wherein the tangential orientation of the first cylindrical section (120a) with respect to the housing body (110) is a tangential orientation of the first longitudinal connector axis (D) of the first cylindrical section (120a) with respect to the circumference of the essentially circular housing surface area (110a) and the essentially cylindrical housing jacket (110b).

2. Housing (100) according to claim 1, wherein the groove (126) extends at an angle of approximately 90° only across part of the circumference of the first cylindrical section (120a) of the angle connector (120).

3. Housing (100) according to any of the preceding claims, wherein an electrically conductive contact of the angle connector (120) with the housing body (110) can be established with the securing pin (111) by means of a contact point of the groove (126).

4. Housing (100) according to claim 3, wherein the contact point results from pressing and frictional engagement of the groove (126) with the securing pin (111).

5. Housing (100) according to any of the preceding claims, wherein the first cylindrical section (120a) of the angle connector (120) comprises an outer sealing ring (125) which is designed to seal the hollow space defined by the housing body (110).

6. Housing (100) according to any of the preceding claims, wherein the first cylindrical section (120a) of the angle connector (120) comprises a locking ring (123) having an outer corrugation (114)

7. Housing (100) according to claim 6, wherein the outer corrugation (114) of the locking ring (123) is designed to engage in an inner corrugation (113) in the housing opening (112) of the housing body (110) in order to form a locking pivoting movement of the angle connector (120) around the first connector longitudinal axis (D) between the first end stop and the second end stop.

8. Housing (100) according to claim 6 or 7, wherein the locking ring (123) is made of plastics material with electrically conductive particles introduced into the plastics material.

9. Housing (100) according to any of claims 6 to 8, wherein the locking ring (123) has at least one slot and is attached to the outer face of the first cylindrical section (120a) of the angle connector (120) and wherein at least one rib (124) is formed on the outer face of the first cylindrical section (120a) of the angle connector (120) and is received in the at least one slot in order to prevent the attached locking ring from rotating relative to the first cylindrical section (120a) of the angle connector (120).

10. Housing (100) according to claim 9, wherein the first cylindrical section (120a) of the angle connector (120) comprises an inner sealing ring (127) which is designed to seal the hollow space defined by the housing body (110) against the locking ring (123).

11. Housing (100) according to any of the preceding claims, wherein the angle connector (120) comprises a second cylindrical section (120b) having a second longitudinal connector axis (C) which extends at an angle, in particular a right angle, to the first longitudinal connector axis (D).

12. Housing (100) according to claim 11, wherein the second cylindrical section (120b) of the angle connector (120) comprises an outer thread (121) and/or a connector insert (122).

13. Housing (100) according to any of the preceding claims, wherein the securing pin (111) comprises a taper-grooved dowel pin (111) which is plugged into a seat (115) of the housing body (110).

14. Sensor, in particular a rotary encoder, comprising a housing (100) according to any of the preceding claims.

## Revendications

1. Boîtier (100) doté d'un corps de boîtier (110), qui délimite une cavité destinée à recevoir les composants électriques et/ou électroniques et une ouverture de boîtier (112), et d'un connecteur coudé (120),
qui présente une première section cylindrique (120a) dotée d'un premier axe longitudinal de connecteur (D), qui est conçu pour être reçu dans une orientation tangentielle par rapport au corps de boîtier (110) dans l'ouverture de boîtier (112),
le corps de boîtier (110) comprenant en outre un goujon de fixation (111), conçu pour s'engager dans une rainure (126) sur un côté extérieur de la première section cylindrique (120a) du connecteur coudé (120) pour fixer une position du connecteur coudé (120) le long du premier axe longitudinal de connecteur (D),
la rainure (126) s'étendant seulement sur une partie de la circonférence de la première section cylindrique (120a) du connecteur coudé (120) pour former une première butée d'extrémité et une seconde butée d'extrémité pour un mouvement de pivotement du connecteur coudé (120) autour du premier axe longitudinal de connecteur (D),
le corps de boîtier (110) comprenant une surface de base de boîtier sensiblement circulaire (110a) et une enveloppe de boîtier sensiblement cylindrique (110b) et l'orientation tangentielle de la première section cylindrique (120a) par rapport au corps de boîtier (110) étant une orientation tangentielle du premier axe longitudinal de connecteur (D) de la première section cylindrique (120a) par rapport à la circonférence de la surface de base de boîtier sensiblement circulaire (110a) et de l'enveloppe de boîtier sensiblement cylindrique (110b).

2. Boîtier (100) selon la revendication 1, la rainure (126) s'étendant selon un angle d'environ 90° uniquement sur la partie de la circonférence de la première section cylindrique (120a) du connecteur coudé (120).

3. Boîtier (100) selon l'une des revendications précédentes, un contact électroconducteur du connecteur coudé (120) avec le corps de boîtier (110) pouvant être établi au moyen d'un point de contact de la rainure (126) avec le goujon de fixation (111).

4. Boîtier (100) selon la revendication 3, le point de contact étant réalisé au moyen d'une liaison par pression et par friction de la rainure (126) avec le goujon de fixation (111).

5. Boîtier (100) selon l'une des revendications précédentes, la première section cylindrique (120a) du connecteur coudé (120) comprenant une bague d'étanchéité extérieure (125) conçue pour assurer l'étanchéité de la cavité délimitée par le corps de boîtier (110).

6. Boîtier (100) selon l'une quelconque des revendications précédentes, la première section cylindrique (120a) du connecteur coudé (120) comprenant une bague d'encliquetage (123) présentant une cannelure extérieure (114).

7. Boîtier (100) selon la revendication 6, la cannelure extérieure (114) de la bague d'encliquetage (123) étant conçue pour s'engager dans une cannelure intérieure (113) dans l'ouverture de boîtier (112) du corps de boîtier (110) pour former un mouvement de pivotement à encliquetage du connecteur coudé (120) autour du premier axe longitudinal de connecteur (D) entre la première butée d'extrémité et la seconde butée d'extrémité.

8. Boîtier (100) selon l'une des revendications 6 ou 7, la bague d'encliquetage (123) étant fabriquée en matière plastique avec des particules électroconductrices incorporées dans la matière plastique.

9. Boîtier (100) selon l'une des revendications 6 à 8, la bague d'encliquetage (123) présentant au moins une fente et étant enfichée sur le côté extérieur de la première section cylindrique (120a) du connecteur coudé (120) et au moins une entretoise (124) étant formée sur le côté extérieur de la première section cylindrique (120a) du connecteur coudé (120), laquelle entretoise étant logée dans la au moins une fente, pour empêcher une rotation de la bague d'encliquetage enfichée par rapport à la première section cylindrique (120a) du connecteur coudé (120).

10. Boîtier (100) selon la revendication 9, la première section cylindrique (120a) du connecteur coudé (120) comprenant une bague d'étanchéité intérieure (127) conçue pour assurer l'étanchéité de la cavité délimitée par le corps de boîtier (110) par rapport à la bague d'encliquetage (123).

11. Boîtier (100) selon l'une des revendications précédentes, le connecteur coudé (120) comprenant une seconde section cylindrique (120b) dotée d'un second axe longitudinal de connecteur (C), qui forme un angle, notamment un angle droit, avec le premier axe longitudinal de connecteur (D).

12. Boîtier (100) selon la revendication 11, la seconde section cylindrique (120b) du connecteur coudé (120) comprenant un filetage extérieur (121) et/ou un insert de connecteur (122).

13. Boîtier (100) selon l'une quelconque des revendications précédentes, le goujon de fixation (111) comprenant un pion de guidage (111) qui est inséré dans un logement (115) du corps de boîtier (110).

14. Capteur, en particulier codeur, doté d'un boîtier (100) selon l'une des revendications précédentes.
